# FASCICULE DE BREVET EUROPEEN

(11) **EP 1 720 395 B1**
(45) Date de publication et mention de la délivrance du brevet: **16.09.2009**
(21) Numéro de dépôt: 06112411.1
(22) Date de dépôt: 10.04.2006
(51) Int. Cl.: H05K 7/20

(54) **Dispositif de ventilation à languettes élastiques de fixation.**
Belüftungsvorrichtung mit Befestigungseinrichtung mit Federstreifen
Ventilatilation device having fixing means with elastic fingers

(30) Priorité: 02.05.2005 FR 0551145
(43) Date de publication de la demande: 08.11.2006
(73) Titulaire: Hispano Mecano Electrica S.A., 08007 Barcelona (ES)
(72) Inventeur: Niubo, Xavier, 08690 Barcelonne (ES)
(74) Mandataire: Bié, Nicolas

(56) Documents cités:
- EP-A- 0 439 667
- WO-A-01/60137
- US-A- 6 099 611

## Description

La présente invention a pour objet un dispositif de ventilation pour armoire électrique, logé dans une ouverture formée sur un panneau de l'armoire électrique, comprenant un boîtier de ventilation apte à recevoir un ventilateur et pouvant être encliqueté dans l'ouverture, sur le panneau de l'armoire électrique.

La demande de brevet n °FR 2 760 259 (brevet correspondant US 6,099,611) décrit un aérateur filtrant pouvant être enclenché dans une ouverture d'une plaque de fixation. Cet aérateur comporte plusieurs éléments d'enclenchements formés de languettes élastiques. Les extrémités de chaque languette présentent des crans disposés en escaliers. Les crans formés en escalier permettent de pouvoir enclencher l'aérateur filtrant sur des plaques de fixation de différentes épaisseurs. Cependant, dans de tels moyens de fixation les crans situés sur une même languette doivent parfaitement coïncider avec la paroi du panneau pour obtenir un maintien sûr dans l'ouverture. Par conséquent, de tels moyens de fixation ne peuvent s'adapter à une large plage d'épaisseurs et le recours à des vis de fixation peut s'avérer nécessaire si la plaque de fixation est trop épaisse.

Les demandes de brevet n °EP 0 439 667 et EP 1262095 décrivent également la fixation d'un boîtier d'un dispositif de ventilation dans une ouverture formée à travers une paroi. Dans ces solutions, l'ajustage du boîtier aux différentes épaisseurs de paroi est réalisé par le mouvement de flexion de quatre languettes identiques situées chacune à un coin du boîtier. Par conséquent, si la paroi est trop épaisse ou pas assez épaisse, la fixation du boîtier peut s'avérer imparfaite ce qui peut occasionner la chute du dispositif ou des dysfonctionnements s'il existe par exemple du jeu entre le boîtier et la paroi.

Le but de l'invention est de proposer un dispositif de ventilation pour armoire électrique pouvant s'adapter sur des panneaux d'une large plage d'épaisseurs.

Ce but est atteint par un dispositif de ventilation d'une armoire électrique, logé dans une ouverture formée à travers un panneau de l'armoire électrique et comprenant un boîtier de ventilation apte à recevoir un ventilateur et à être introduit dans l'ouverture, ledit boîtier de ventilation comprenant,
- une bride formant un plan d'appui venant en butée contre une face du panneau de manière à limiter l'introduction du boîtier de ventilation dans l'ouverture,
- un dispositif de fixation pour fixer le boîtier de ventilation dans l'ouverture, par encliquetage sur le panneau, lorsque la bride vient en butée par son plan d'appui contre le panneau, caractérisé en ce que,
- le dispositif de fixation comporte plusieurs groupes de plusieurs languettes élastiques de fixation, et
- dans chaque groupe, chaque languette de fixation ménage un espace différent par rapport au plan d'appui en vue de pouvoir s'adapter à différentes épaisseurs de panneau.

Selon l'invention, chacune des languettes de fixation d'un groupe travaille en fonction de l'épaisseur du panneau correspondante ce qui permet de pouvoir ajuster le boîtier de ventilation sur une large plage d'épaisseurs en évitant les inconvénients de l'art antérieur. Une languette de fixation dans chacun des groupes étant toujours adaptée à l'épaisseur du panneau, le boîtier de ventilation se trouve toujours parfaitement fixé sur le panneau quelle que soit cette épaisseur.

Selon une particularité, dans chaque groupe, les languettes de fixation sont juxtaposées.

Selon un mode de réalisation préféré de l'invention, le dispositif comprend des languettes pour un centrage et un ajustement du boîtier de ventilation dans l'ouverture. Ces languettes de centrage présentent un intérêt tout particulier lorsque l'ouverture a été formée de manière irrégulière.

Selon une autre particularité, deux groupes de languettes de fixation sont disposés sur le boîtier de ventilation suivant au moins deux rangées parallèles.

Selon une autre particularité, chaque languette de fixation comporte une extrémité solidaire du boîtier de ventilation et s'étend en direction du plan d'appui jusqu'à une extrémité libre.

Selon une autre particularité, chaque languette de fixation est mobile en flexion lors de l'encliquetage du boîtier de ventilation dans l'ouverture, autour d'un axe de rotation parallèle au plan d'appui.

Selon l'invention, chaque languette de fixation comporte :
- Une rampe suivant laquelle le boîtier de ventilation est engagé sur le panneau lors de l'encliquetage,
- un organe de blocage réalisant un maintien du boîtier de ventilation sur le panneau.

Selon une particularité, ladite rampe définit une surface inclinée vers l'extérieur du boîtier de ventilation en direction du plan d'appui et parallèle à l'axe de rotation.

Selon une première et une deuxième configurations, chaque languette de fixation (5, 6) est constituée d'une branche sur laquelle est formée la rampe prolongée, en direction du plan d'appui, d'une surface d'appui contre laquelle vient s'appuyer le panneau, ladite surface d'appui définissant l'organe de blocage et étant inclinée vers l'intérieur du boîtier de ventilation et parallèle à l'axe de rotation.

Selon une autre configuration, chaque languette de fixation comporte deux branches, une première branche constituant la rampe, solidaire du boîtier de ventilation et flexible par rapport au boîtier de ventilation, prolongée d'une seconde branche flexible par rapport à la première branche et constituant l'organe de blocage.

Selon une particularité de cette dernière configuration, la languette de fixation comporte des moyens empêchant une extraction frontale du boîtier de ventilation, constitués par exemple d'une entaille formée sur la surface de la rampe parallèlement à l'axe de rotation.

Selon une autre configuration, les languettes de fixation comprennent deux branches, l'une d'elle terminée par l'extrémité libre étant repliée sur l'autre et servant de rampe, l'organe de blocage étant constitué de l'extrémité libre de la languette élastique.

Selon l'invention, le boîtier de ventilation comporte une jupe formant avec la bride un épaulement perpendiculaire au plan d'appui et enfoncée dans l'ouverture, cette jupe ayant une section sensiblement rectangulaire ou carrée définissant quatre flancs portant les languettes de fixation. Les groupes de languettes de fixation sont identiques et répartis sur deux flancs opposés de la jupe. Les languettes de centrage sont formées sur les deux flancs opposés de la jupe et deux groupes de languettes de fixation sont prévus sur chaque flanc de part et d'autre des languettes de centrage (9).

D'autres caractéristiques et avantages vont apparaître dans la description détaillée qui suit en se référant à un mode de réalisation donné à titre d'exemple et représenté par les dessins annexés sur lesquels :
- La figure 1A représente en perspective un boîtier de ventilation portant des languettes élastiques de fixation d'une première configuration.
- La figure 1B représente en détail un groupe de languettes de fixation de la première configuration.
- La figure 2 représente l'arrière du boîtier de ventilation de la figure 1A.
- La figure 3 représente un côté du boîtier de ventilation de la figure 1A, portant les languettes de fixation.
- La figure 4 représente une coupe transversale du boîtier de ventilation selon A-A sur la figure 2 ainsi que la grille et le ventilateur pouvant être rapportés sur ce boîtier.
- Les figures 5A et 5B représentent en coupe transversale suivant A-A sur la figure 2, l'une des languettes de fixation de la première configuration, respectivement avant encliquetage sur un panneau de faible épaisseur et encliquetée sur ce panneau.
- Les figures 6A et 6B représentent en coupe transversale suivant B-B sur la figure 2, l'une des languettes de fixation de la première configuration, respectivement avant encliquetage sur un panneau d'épaisseur plus importante et encliquetée sur ce panneau.
- La figure 7A représente en perspective un boîtier de ventilation portant des languettes élastiques de fixation d'une seconde configuration.
- La figure 7B représente en détail un groupe de languettes de fixation de cette seconde configuration.
- La figure 8 représente l'arrière du boîtier de ventilation de la figure 7A.
- La figure 9 représente un côté du boîtier de ventilation de la figure 7A, portant les languettes de fixation.
- Les figures 10A à 10C représentent une coupe transversale du boîtier de ventilation respectivement selon A-A, B-B et C-C sur la figure 8.
- Les figures 11A et 11B représentent en coupe transversale suivant A-A sur la figure 8, l'une des languettes de fixation de la seconde configuration, respectivement avant encliquetage sur un panneau de faible épaisseur et encliquetée sur ce panneau.
- Les figures 12A et 12B représentent en coupe transversale suivant B-B sur la figure 8, l'une des languettes de fixation de la seconde configuration, respectivement avant encliquetage sur un panneau d'épaisseur moyenne et encliquetée sur ce panneau.
- Les figures 13A et 13B représentent en coupe transversale suivant C-C sur la figure 8, l'une des languettes de fixation de la seconde configuration, respectivement avant encliquetage sur un panneau d'épaisseur plus importante et encliquetée sur ce panneau.
- La figure 14A représente en perspective un boîtier de ventilation portant des languettes élastiques de fixation d'une troisième configuration.
- La figure 14B représente en détail, un groupe de languettes de fixation de cette troisième configuration.
- La figure 15 représente l'arrière du boîtier de ventilation de la figure 14A.
- La figure 16 représente un côté du boîtier de ventilation de la figure 14A, portant les languettes de fixation.
- Les figures 17A et 17B représentent une coupe transversale du boîtier de ventilation selon A-A sur la figure 15, respectivement avant encliquetage sur un panneau de l'armoire et encliqueté sur ce panneau.
- Les figures 18A et 18B représentent en coupe transversale suivant A-A sur la figure 15, l'une des languettes de fixation de la troisième configuration, respectivement avant encliquetage sur un panneau de l'armoire et encliquetée sur ce panneau.
- La figure 19A représente en perspective un boîtier de ventilation portant des languettes élastiques de fixation d'une quatrième configuration.
- La figure 19B représente sur le boîtier de ventilation de la figure 19A, en détail, un groupe de languettes de fixation de cette quatrième configuration.
- Les figures 20A et 20B représentent une coupe transversale du boîtier de ventilation réalisée au niveau d'une languette de fixation respectivement avant encliquetage sur un panneau de l'armoire et encliquetée sur ce panneau.
- Les figures 21A et 21B représentent en détail et en coupe transversale une languette de cette quatrième configuration respectivement avant encliquetage sur un panneau de l'armoire et encliquetée sur ce panneau.
- Les figures 22A, 22B, 23A et 23B illustrent à l'aide de quatre coupes transversales le fléchissement des languettes de centrage lorsque le boîtier est encliqueté sur un panneau de l'armoire de faible épaisseur ou sur un panneau d'épaisseur plus importante.
- La figure 24 illustre en coupe transversale et en détail le mouvement de fléchissement réalisé par une languette de centrage.
- La figure 25 représente une grille de ventilation pouvant être rapportée sur le boîtier de ventilation représenté sur les figures précédentes.

Dans la suite de la description, les termes "avant" ou "devant" et "arrière" ou "derrière" doivent être compris en prenant comme référence un panneau vertical sur lequel le boîtier de ventilation est fixé. Les termes "interne", "intérieur" ou "externe" et "extérieur" doivent être compris en se référant au boîtier de ventilation.

Un dispositif de ventilation effectue la ventilation d'une armoire électrique dans laquelle sont logés des organes ou appareils électriques. De manière connue, l'armoire électrique est composée de plusieurs panneaux 4 solidaires entre eux formant par exemple un ensemble parallélépipédique.

Le dispositif de ventilation selon l'invention est destiné à être fixé au travers d'une ouverture 2 formée à travers un panneau 4 de l'armoire électrique.

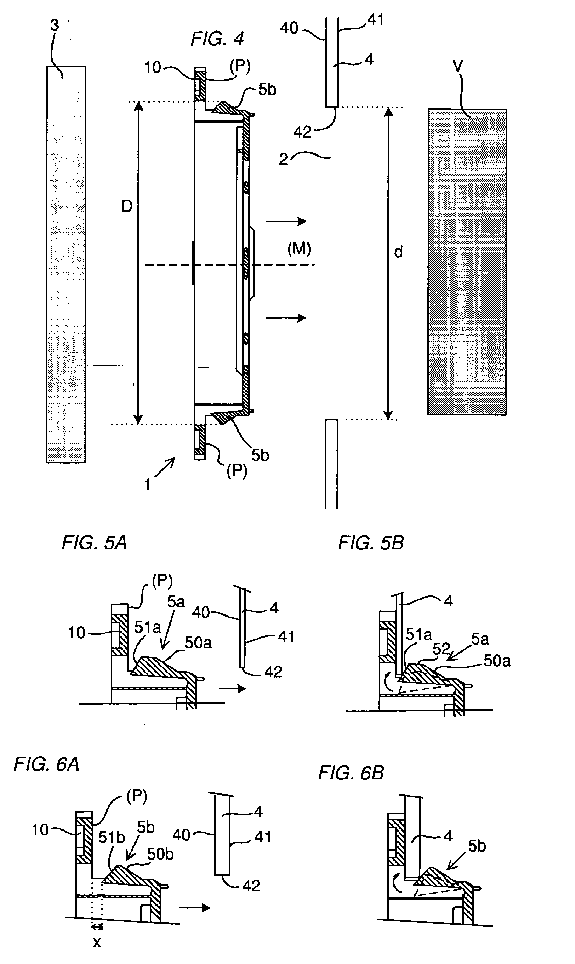

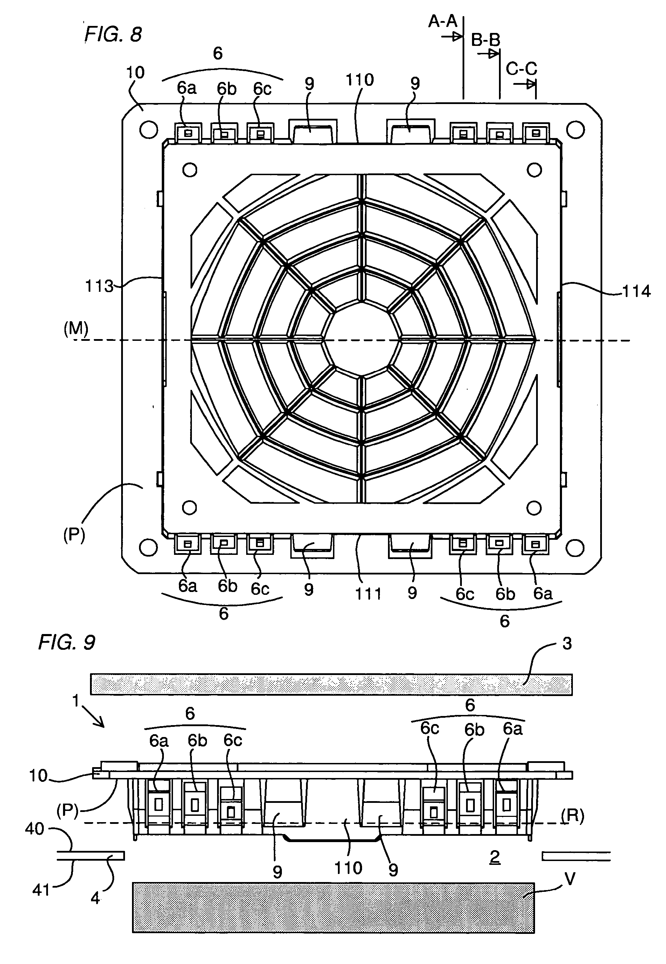

De manière connue, le dispositif de ventilation selon l'invention comporte un boîtier 1 de ventilation, par exemple en plastique, intégrant un ventilateur ou destiné à recevoir un ventilateur V (figures 4 et 9). Le boîtier 1 de ventilation comporte par exemple un support moteur présentant vers l'avant une bride 10 plane sur laquelle peut venir s'encliqueter une grille 3 lamellaire (figures 4, 9 et 25) portant un filtre. Le moteur et le ventilateur V du dispositif sont rapportés directement ou par l'intermédiaire d'un adaptateur (non représenté) à l'arrière du support moteur. Cet adaptateur peut être réalisé en une pièce avec le support moteur.

Le boîtier 1 de ventilation est introduit dans l'ouverture 2 suivant un axe principal perpendiculaire au plan défini par les faces avant 40 et arrière 41 du panneau 4 et sa fixation est réalisée par encliquetage sur le bord 42 du panneau définissant l'ouverture. L'ouverture 2 est par exemple de forme carrée ou rectangulaire.

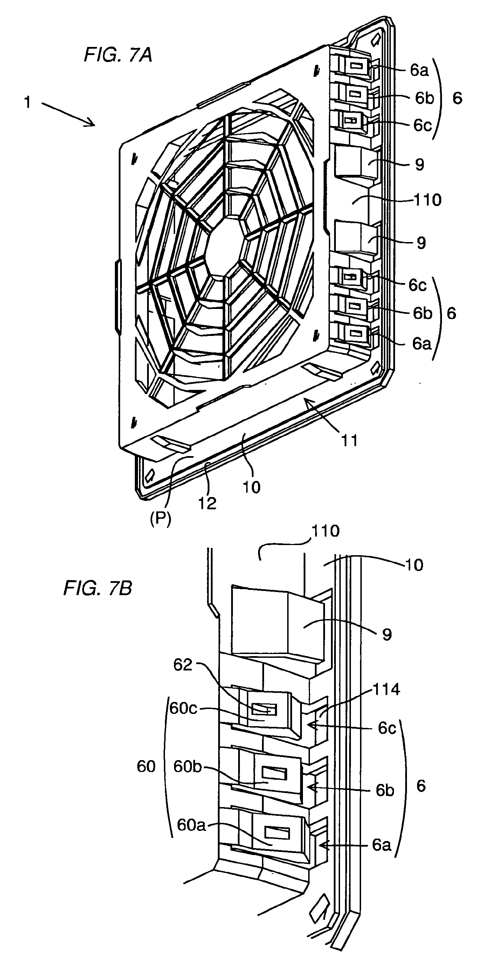

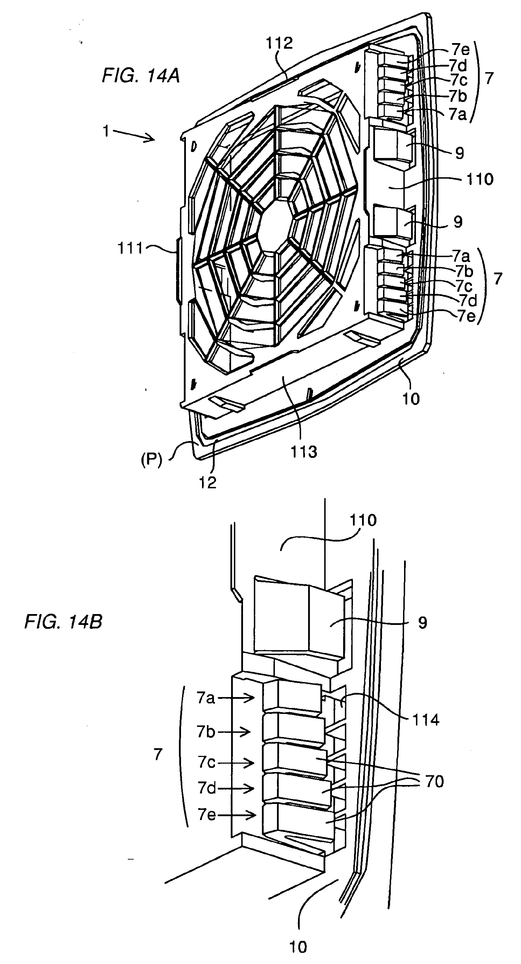

La bride 10 forme sur sa face arrière un plan d'appui (P) venant s'appuyer contre la face avant 40 du panneau 4 pour limiter l'introduction du boîtier 1 dans l'ouverture 2. La bride 10 peut comporter sur sa face formant le plan d'appui (P) une rainure 12 (figures 7A et 14A) destinée à loger un joint d'étanchéité.

Selon l'invention, la bride 10 plane coopère avec des languettes élastiques de fixation 5, 6, 7, 8 pour fixer le boîtier 1 de ventilation sur le panneau 4. Des languettes élastiques de centrage 9 sont également prévues pour ajuster le boîtier 1 de ventilation dans l'ouverture 2 et permettre aux languettes de fixation 5, 6, 7, 8 de travailler correctement.

Lors de l'introduction du boîtier 1 dans l'ouverture 2, les languettes de fixation 5, 6, 7, 8 et de centrage 9 fléchissent élastiquement et sont repoussées vers l'intérieur du boîtier 1 au contact du bord 42 de l'ouverture 2. Lorsque le plan d'appui (P) de la bride 10 s'applique contre la face avant 40 du panneau 4, les languettes de fixation 5, 6, 7, 8 viennent s'encliqueter derrière le panneau, sur la face arrière 41 de celui-ci.

Selon l'invention, la bride 10 présente vers l'arrière un épaulement constitué d'une jupe 11 perpendiculaire à son plan d'appui (P), qui selon la forme de l'ouverture 2, est par exemple de section carrée ou rectangulaire. La jupe 11 présente donc quatre flancs latéraux 110, 111, 112 , 113 sur deux desquels sont formées les languettes de fixation 5, 6, 7, 8 et de centrage 9. Les languettes de fixation 5, 6, 7, 8 ainsi que les languettes de centrage 9 sont disposées symétriquement par rapport à un plan (M) médian du boîtier sur deux flancs 110, 111 opposés de la jupe 11 du boîtier. Les languettes de centrage 9 sont par exemple au nombre de deux sur chaque flanc 110, 111 et sont centrées sur le flanc 110, 111 de la jupe 11. Chaque flanc 110, 111 de la jupe 11 porte deux groupes de languettes de fixation 5, 6, 7, 8 montés par exemple symétriquement de part et d'autre des languettes de centrage 9. Chaque groupe de languettes de fixation comporte plusieurs languettes de fixation 5, 6, 7, 8 ayant des caractéristiques différentes en vue de pouvoir s'encliqueter sur des panneaux 4 de différentes épaisseurs. Dans un groupe, les languettes de fixation 5, 6, 7, 8 sont conçues de manière que chacune d'elles travaille lorsqu'elle est adaptée à l'épaisseur du panneau 4 sur lequel le boîtier de ventilation 1 est fixé.

Selon l'invention, chaque languette de fixation 5, 6, 7, 8 et de centrage 9 comporte une extrémité fixée sur le boîtier 1 et une extrémité libre de manière à pouvoir être mobile en flexion autour d'un axe de rotation (R) parallèle au plan d'appui (P) de la bride 10 et au plan médian (M). Chaque flanc 110, 111 de la jupe 11 portant les languettes de fixation 5, 6, 7, 8 et de centrage 9 présente des évidements 114 dans lesquels les languettes peuvent pivoter lors de l'encliquetage du boîtier 1 dans l'ouverture 2.

Sur chaque flanc 110, 111 de la jupe, les axes de rotation (R) des languettes élastiques de fixation 5, 6, 7, 8 et de centrage 9 sont parallèles et idéalement confondus.

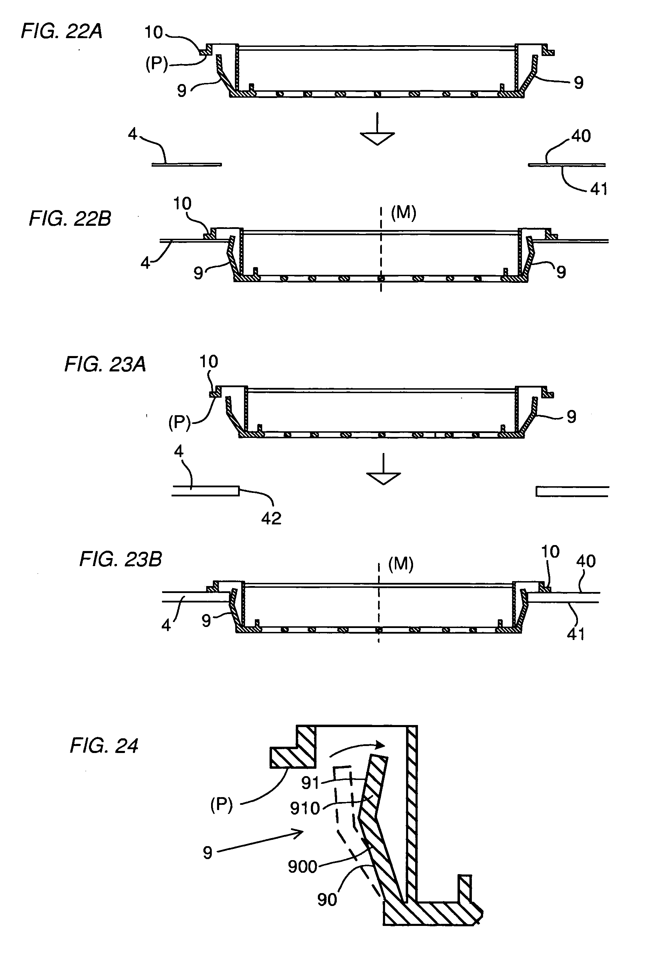

Selon l'invention, les languettes de centrage 9 du boîtier 1 de ventilation dans l'ouverture 2 sont par exemple au nombre de deux sur chacun des deux flancs 110, 111 de la jupe 11 et comportent chacune deux branches 900, 910 (figure 24), une première branche 900 solidaire du boîtier 1 et flexible par rapport au boîtier 1, prolongée vers l'avant du boîtier 1 d'une seconde branche 910 formant une liaison rigide avec la première branche 900. La première branche 900 définit une surface inclinée constituant une rampe 90 sur laquelle le bord 42 de l'ouverture 2 vient s'appuyer lors de l'introduction du boîtier 1 dans l'ouverture 2 et la seconde branche 910 définit une surface 91 qui, au repos, est sensiblement perpendiculaire aux faces 40, 41 du panneau 4 (figures 22A et 23A). En direction du plan d'appui (P) de la bride 10, la rampe 90 est inclinée vers l'extérieur du boîtier de ventilation.

Comme représenté sur les figures 22A à 23B, lors de l'encliquetage du boîtier, la première branche 900 fléchit au contact du bord 42 de l'ouverture jusqu'à l'enclenchement complet du boîtier 1 (position en traits pleins sur la figure 24). La seconde branche 910 vient alors s'appuyer contre le bord 42 correspondant de l'ouverture 2 (figures 22B et 23B). En fonction de l'épaisseur du panneau 4, la seconde branche 910 présente une zone d'appui sur le bord 42 de l'ouverture 2 de taille plus ou moins importante. Lorsque l'épaisseur est importante comme sur la figure 23B, cette zone est étendue. Le boîtier 1 de ventilation n'est bien positionné sur le panneau 4 que si toutes les languettes de centrage 9 sont bien en appui sur une partie respective du bord 42 de l'ouverture 2. Ces languettes de centrage 9 sont toutes identiques et peuvent s'adapter à différentes épaisseurs de panneau 4.

Chaque languette de fixation 5, 6, 7, 8 comporte une surface perpendiculaire aux faces 40, 41 du panneau 4 et parallèle à son axe de rotation, formant une rampe 50, 60, 70, 80 sur laquelle le bord 42 de l'ouverture 2 vient s'appuyer lors de l'introduction du boîtier 1 dans l'ouverture 2. En direction du plan d'appui (P) de la bride 10, la rampe 50, 60, 70, 80 est inclinée vers l'extérieur du boîtier. La rampe 50, 60, 70, 80 est complétée par un organe de blocage permettant le maintien par encliquetage du boîtier 1 sur le panneau 4. Selon l'invention, les languettes de fixation 5, 6, 7, 8 sont différentes les unes des autres de manière à définir entre leur organe de blocage et le plan d'appui (P) de la bride 10 un espace différent afin de pouvoir s'adapter à des épaisseurs de panneau différentes. Chaque groupe de languettes comporte par exemple des caractéristiques différentes afin de pouvoir encliqueter un même boîtier 1 sur des panneaux d'épaisseurs différentes.

Il est bien entendu que pour pouvoir réaliser un encliquetage du boîtier 1 dans l'ouverture 2, la distance d entre les deux bords opposés de l'ouverture 2 recevant les languettes de fixation 5, 6, 7, 8 doit être inférieure à la distance D séparant les points les plus éloignés de deux languettes de fixation 5, 6, 7, 8 opposées et symétriques par rapport au plan médian (M) du boîtier de ventilation 1 (figure 4).

Différentes configurations de languettes de fixation 5, 6, 7, 8 sont présentées ci-dessous. Il est bien entendu que les languettes de centrage 9 peuvent être associées aux languettes de fixation 5, 6, 7, 8 de toutes les configurations.

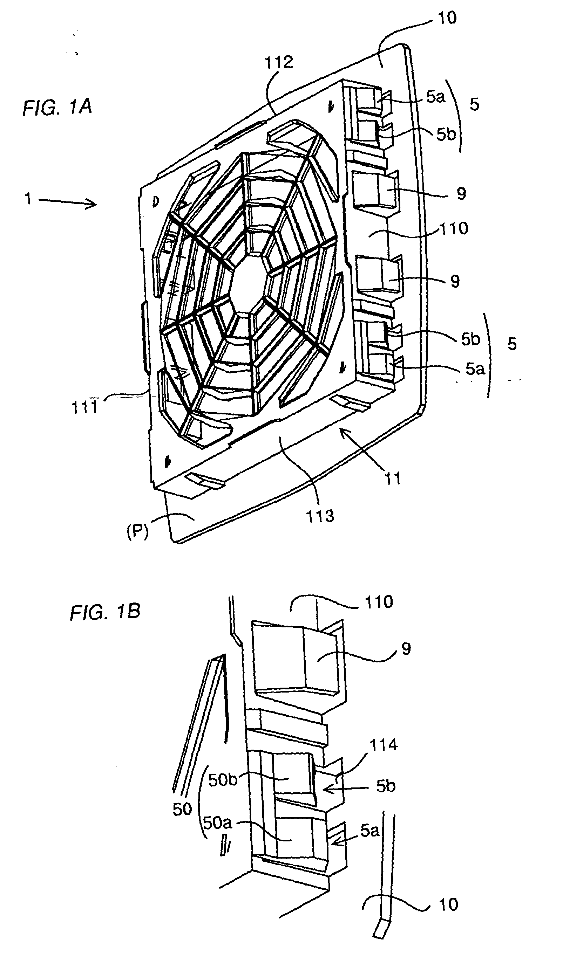

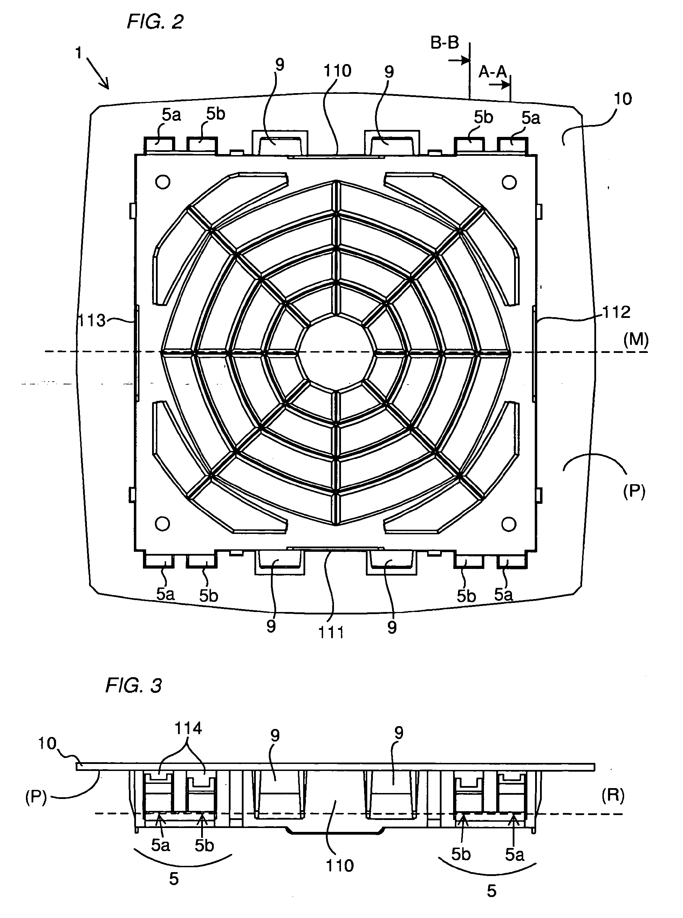

Selon une première configuration représentée en figures 1A à 6B, chaque languette de fixation 5, 5a, 5b est constituée d'une branche unique solidaire du boîtier 1 par l'une de ses extrémités. La forme de cette branche définit deux portions, une première portion constituant la rampe 50a, 50b précitée, prolongée vers l'avant du boîtier 1 d'une seconde portion 51a, 51b définissant une surface d'appui 51a, 51b constituant l'organe de blocage. La surface d'appui 51a, 51b est en forme de U afin de rigidifier la languette (figure 3), plane et parallèle à l'axe de rotation (R) et en direction de la bride 10, inclinée vers l'intérieur du boîtier 1. La face avant 40 du panneau 4 définit avec le bord 42 de l'ouverture 2 une arête qui pour l'encliquetage du boîtier 1 vient s'appuyer contre la surface d'appui 51a, 51b.

Selon l'invention, compte tenu de l'inclinaison de la pente de la surface d'appui 51a, 51b, une même languette 5 peut être adaptée pour maintenir des panneaux de différentes épaisseurs. Dans un groupe de languettes 5, plusieurs languettes de fixation 5a, 5b différentes sont juxtaposées afin de pouvoir s'adapter à différentes épaisseurs de panneau. Elles sont par exemple au nombre de deux dans chaque groupe présent de part et d'autre des languettes de centrage. La différence entre les deux languettes de fixation 5a, 5b porte sur la distance entre l'extrémité libre de la languette de fixation 5a, 5b et le plan d'appui de la bride 10 et sur l'inclinaison de la surface d'appui 51a, 51b. En proposant dans chaque groupe de languettes 5, plusieurs languettes de fixation disposant de caractéristiques différentes, il est possible d'encliqueter un même boîtier sur des panneaux de différentes épaisseurs sans modifier sa structure. Sur les figures 5A et 5B est représentée une languette de fixation 5a adaptée pour fixer le boîtier 1 sur des panneaux de fines épaisseurs. La distance séparant l'extrémité libre de la languette 5a du plan d'appui (P) de la bride 10 est très faible, voire nulle et la pente de sa surface d'appui 51a est fortement inclinée, ce qui ménage un espace très limité. Sur les figures 6A et 6B, l'espace ménagé est plus important du fait que la distance x séparant l'extrémité libre de la languette 5b du plan d'appui (P) de la bride 10 est plus importante et que la pente de sa seconde portion 51b est beaucoup moins prononcée.

Sur les figures 5A et 5b, on peut remarquer que entre la rampe 50a et la surface d'appui 51a, la languette de fixation 5a peut présenter un plateau 52 qui au repos est parallèle au flanc de la jupe sur lequel elle est fixée.

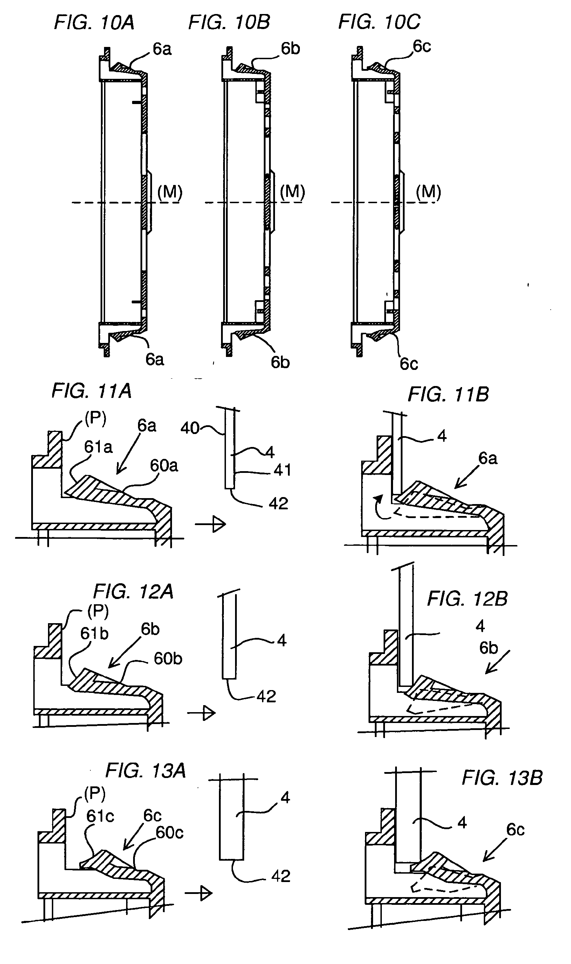

Selon une seconde configuration (figures 7A à 13B), presque identique en tous points à la première configuration, la surface d'appui 61a, 61b, 61c de l'organe de blocage est courbe, la courbure étant réalisée vers l'intérieur du boîtier 1. En outre la rampe 60 présente un évidement 62 prévu pour recevoir par exemple l'extrémité d'un tournevis pour permettre le démontage du boîtier de ventilation 1. Comme précédemment, en jouant sur la distance entre l'extrémité libre de la languette 6 et sur la pente de l'organe de blocage, le boîtier 1 de ventilation peut être encliqueté sur des panneaux de différentes épaisseurs sans modifier sa structure. Dans cette seconde configuration, chaque groupe de languettes de fixation 6 disposé de part et d'autres des languettes de centrage 9 peut comporter trois languettes de fixation 6a, 6b, 6c distinctes. Les figures 11A et 11B représentent une languette 6a de fixation adaptée à l'encliquetage du boîtier sur un panneau 4 de fine épaisseur dont l'extrémité libre est proche du plan d'appui (P) de la bride 10. La pente de sa surface d'appui 61a est cependant moins inclinée que celle de la surface d'appui 61b des languettes de fixation 6b représentées en figures 12A et 12B. Sur ces figures 12A et 12B, l'extrémité libre est cependant plus éloignée du plan d'appui (P) de la bride 10 ce qui lui permet d'accueillir des panneaux 4 de plus fortes épaisseurs. Sur les figures 13A et 13B, les languettes de fixation 6c sont adaptées pour recevoir des panneaux de fortes épaisseurs et elles présentent une surface d'appui 61c fortement inclinée et une extrémité libre très éloignée du plan d'appui (P) de la bride 10 ce qui permet de ménager un espace très important.

Lors de l'encliquetage du boîtier 1 dans l'ouverture 2, le contact du bord 42 de l'ouverture 2 contre chacune des languettes 6a, 6b, 6c d'un groupe provoque la flexion de celles-ci (position marquée en pointillés sur les figures 11B, 12B et 13B). Lorsque le plan d'appui (P) de la bride 10 est en butée contre la face avant 40 du panneau 4, le bord de l'ouverture 2 s'engage dans l'espace ménagé entre les languettes de fixation 6a, 6b, 6c adaptées à l'épaisseur du panneau et la bride 10. Lors de l'encliquetage, les languettes 6a, 6b, 6c reviennent vers leur position initiale jusqu'à ce que leur surface d'appui 61a, 61b, 61c soit en contact avec le panneau 4 (en traits pleins sur les figures 11B, 12B et 13B). Selon l'épaisseur du panneau (figures 11A et 11B ou figures 12A et 12B ou figures 13A et 13B), l'une des languettes de fixation 6a, 6b, 6c de chaque groupe se trouve adaptée pour maintenir le boîtier 1 de ventilation sur le panneau 4.

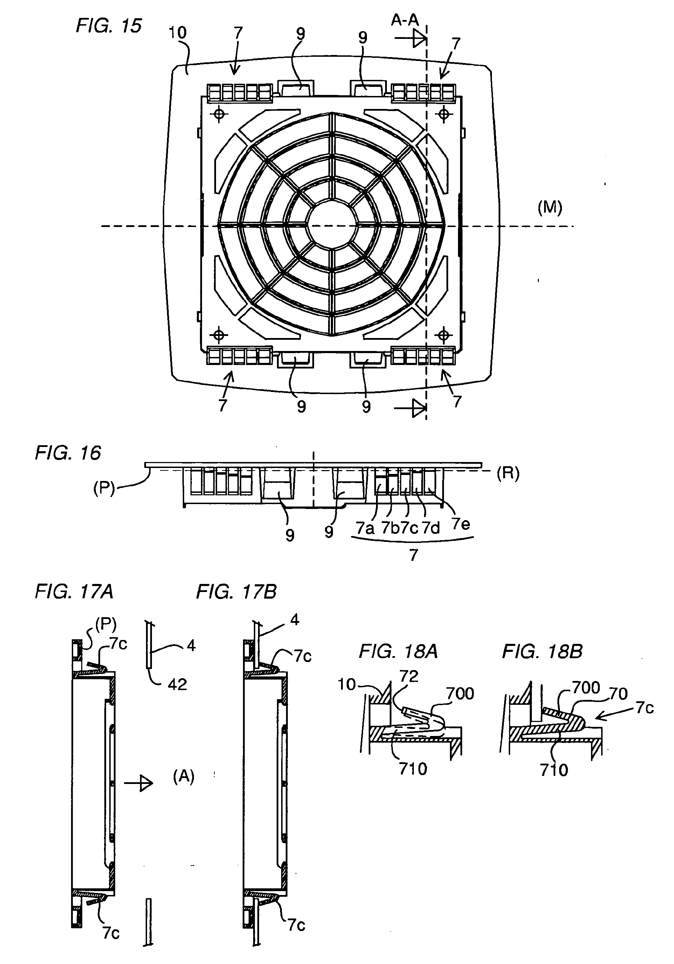

Selon une troisième configuration (figures 14A à 18B), chaque languette de fixation 7 est constituée de deux branches successives, une première branche 710 étant reliée au boîtier 1 de fixation et une seconde branche 700 étant repliée sur la première. La première branche 710 est fixée vers l'avant du boîtier 1 et s'étend vers l'arrière de celui-ci. La seconde branche 700 repliée sur la première s'étend donc vers l'avant du boîtier 1 et se termine par une extrémité libre 72. Cette seconde branche 700 définit une rampe 70 et l'extrémité libre 72 constitue l'organe de blocage. Sur les deux flancs 110, 111 opposés de la jupe 11, chaque groupe de languettes 7 présent de part et d'autres des languettes de centrage 9 comporte plusieurs languettes 7a, 7b, 7c, 7d, 7e juxtaposées de cette configuration. On fait varier la distance entre l'extrémité libre de chaque languette 7 par rapport au plan d'appui (P) de la bride 10 afin de pouvoir accueillir des panneaux 4 de différentes épaisseurs. Sur les figures 15 et 16, cinq languettes 7a, 7b, 7c, 7d, 7e sont par exemple alignées de part et d'autre des languettes de centrage 9, la distance entre l'extrémité libre et le plan d'appui (P) de la bride 10 variant d'une languette à l'autre. Une première languette 7a présente par exemple une extrémité libre plus éloignée du plan d'appui de la bride 10 que l'extrémité libre de la languette adjacente 7b et sera ainsi mieux adaptée pour maintenir le boîtier 1 sur des panneaux 4 de plus forte épaisseur que la languette adjacente 7b.

En référence aux figures 17A à 18B, lors de l'encliquetage du boîtier 1 dans l'ouverture, la rampe 70 d'une languette de fixation 7c est au contact du bord 42 de l'ouverture 2 et la languette de fixation 7c fléchit donc vers l'intérieur du boîtier 1 (en pointillés sur la figure 18A). Lorsque le plan d'appui (P) de la bride 10 arrive en butée contre la face avant 40 du panneau 4, la languette de fixation 7c remonte jusqu'à ce que son extrémité libre 72 vienne en appui contre la face arrière 41 du panneau 4 (figure 18B). La bride 10 et l'extrémité libre de la languette 7c enserre donc le bord 42 de l'ouverture 2. Les languettes de fixation ménageant un espace trop étroit pour l'épaisseur du panneau restent en flexion et ne participent pas au maintien du boîtier 1 de ventilation dans l'ouverture 2.

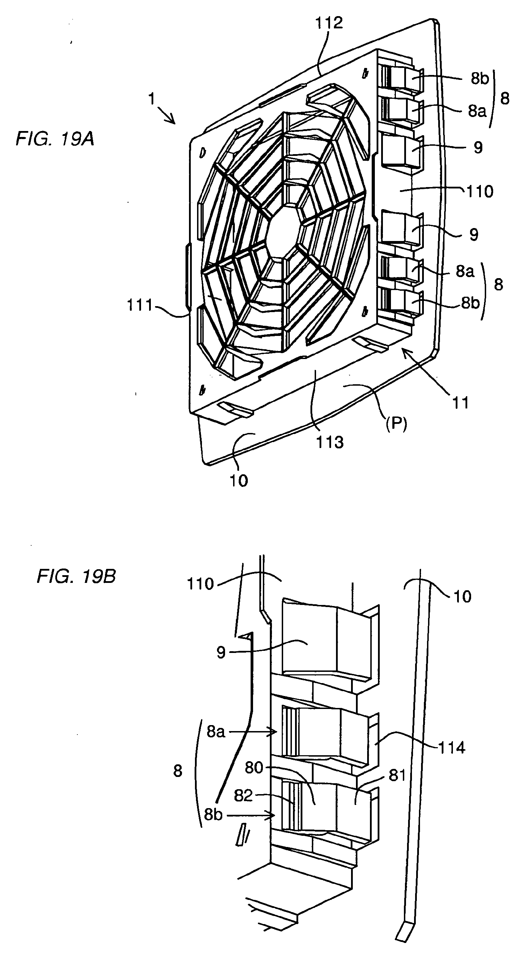

Selon une quatrième configuration (figures 19A à 21B), chaque languette de fixation 8 peut comporter deux branches, une première branche 800 définissant la rampe 80, fixée sur le boîtier 1 et flexible par rapport au boîtier 1, prolongée vers l'avant du boîtier 1, en direction du plan d'appui (P) de la bride 10, d'une seconde branche 810 flexible par rapport à la première, définissant une surface d'appui 81 constituant l'organe de blocage. La rampe 80 est inclinée, en direction du plan d'appui (P) de la bride 10, vers l'extérieur du boîtier 1 tandis que la surface d'appui 81 de la seconde branche 810 est perpendiculaire aux faces 40, 41 du panneau 4. Selon l'invention, la première branche 800 comporte sur sa surface une entaille 82 formée suivant son axe de rotation (R) et constituant une ligne de déformation autorisant un fléchissement de la languette 8 vers l'extérieur du boîtier 1 dans le cas d'une extraction frontale du boîtier 1 lorsque celui-ci est déjà encliqueté sur le panneau 4. Une seconde entaille 83 est formée à la jonction des deux branches, sous celles-ci, afin de favoriser la flexion de la seconde branche vers l'intérieur du boîtier 1. Dans cette configuration, chaque flanc 110, 111 de la jupe porte par exemple deux groupes identiques de deux languettes de fixation disposés de part et d'autre des languettes de centrage 9. Dans chaque groupe, une première languette de fixation 8a présente par exemple une extrémité libre plus éloignée du plan d'appui de la bride 10 que l'extrémité libre de la deuxième languette de fixation 8b. Ainsi, la deuxième languette de fixation 8b sera plus adaptée pour maintenir le boîtier 1 sur des panneaux 4 de plus faible épaisseur.

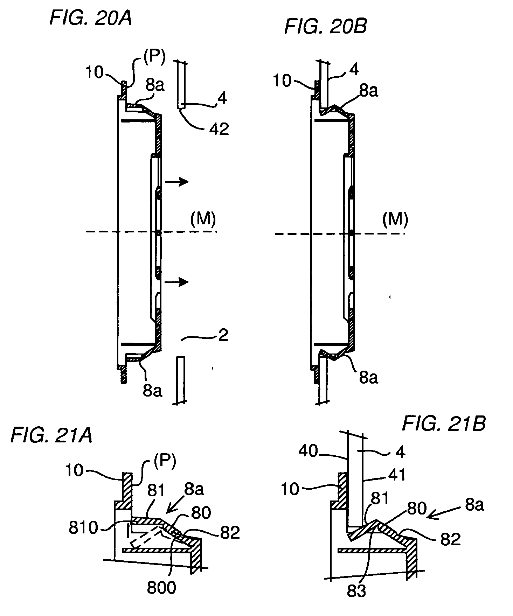

En référence aux figures 20A à 21B, lors de l'encliquetage du boîtier 1, au contact du bord de l'ouverture, la première branche 800 de la languette 8a fléchit au niveau de son extrémité solidaire du boîtier 1 (position marquée par les traits en pointillés sur la figure 21A). Lorsque la bride 10 vient par son plan d'appui (P) en butée contre la face avant 40 du panneau 4, la première branche 800 remonte et la seconde branche 810 reste fléchie de sorte que sa surface d'appui 81 est alors au contact du panneau 4 permettant le maintien de celui-ci (figure 21B). Contrairement aux première, seconde et troisième configurations, l'ajustement à l'épaisseur du panneau est réalisé grâce à l'élasticité de la seconde branche 810 par rapport à la première.

Dans cette quatrième configuration, en cas de tentative d'extraction frontale du dispositif de ventilation, grâce à son entaille 82, la languette de fixation 8 fléchit vers l'extérieur du boîtier 1 ce qui empêche l'extraction.

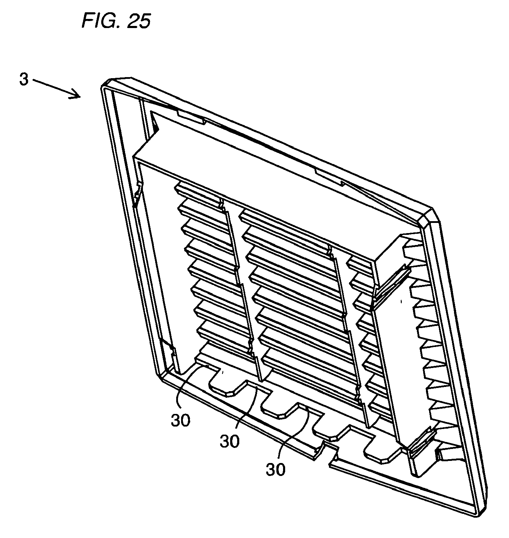

Selon l'invention, afin de permettre une évacuation d'eau projetée accidentellement dans l'armoire, la paroi interne inférieure du boîtier 1 de ventilation peut être inclinée de l'arrière vers l'avant. L'eau s'écoulant suivant cette paroi inclinée peut être évacuée à travers des ouvertures 30 prévues sur la grille 3 et situées dans le prolongement de la paroi inclinée (figure 25).

Il est bien entendu que l'on peut, sans sortir du cadre de l'invention, imaginer d'autres variantes et perfectionnements de détail et de même envisager l'emploi de moyens équivalents.

## Revendications

1. Dispositif de ventilation d'une armoire électrique, logé dans une ouverture (2) formée à travers un panneau (4) de l'armoire électrique et comprenant un boîtier (1) de ventilation apte à recevoir un ventilateur (V) et à être introduit dans l'ouverture (2), ledit boîtier de ventilation comprenant,
- une bride (10) formant un plan d'appui (P) venant en butée contre une face (40) du panneau (4) de manière à limiter l'introduction du boîtier (1) de ventilation dans l'ouverture (2),
- un dispositif de fixation pour fixer le boîtier (1) de ventilation dans l'ouverture, par encliquetage sur le panneau (4), lorsque la bride (10) vient en butée par son plan d'appui (P) contre le panneau (4), **caractérisé en ce que**,
- le dispositif de fixation comporte plusieurs groupes de plusieurs languettes élastiques de fixation (5, 6, 7, 8), et
- dans chaque groupe, chaque languette de fixation (5a-5b, 6a-6c, 7a-7e, 8a-8b) ménage un espace différent par rapport au plan d'appui (P) en vue de pouvoir s'adapter à différentes épaisseurs de panneau (4).

2. Dispositif selon la revendication 1, **caractérisé en ce que** dans chaque groupe, les languettes de fixation (5, 6, 7, 8) sont juxtaposées.

3. Dispositif selon la revendication 1, **caractérisé en ce qu'**il comprend des languettes (9) pour un centrage et un ajustement du boîtier de ventilation dans l'ouverture.

4. Dispositif selon l'une des revendications 1 à 3, **caractérisé en ce que** deux groupes de languettes de fixation (5, 6, 7, 8) sont disposés sur le boîtier de ventilation (1) suivant au moins deux rangées parallèles.

5. Dispositif selon l'une des revendications 1 à 4, **caractérisé en ce que** chaque languette de fixation (5, 6, 7, 8) comporte une extrémité solidaire du boîtier de ventilation (1) et s'étend en direction du plan d'appui (P) jusqu'à une extrémité libre.

6. Dispositif selon l'une des revendications 1 à 5, **caractérisé en ce que** chaque languette de fixation (5, 6, 7, 8) est mobile en flexion lors de l'encliquetage du boîtier de ventilation (1) dans l'ouverture (2), autour d'un axe de rotation (R) parallèle au plan d'appui (P).

7. Dispositif selon l'une des revendications 1 à 6, **caractérisé en ce que** chaque languette de fixation (5, 6, 7, 8) comporte :
- Une rampe (50, 60, 70, 80) suivant laquelle le boîtier de ventilation (1) est engagé sur le panneau (4) lors de l'encliquetage,
- un organe de blocage réalisant un maintien du boîtier de ventilation (1) sur le panneau (4).

8. Dispositif selon la revendication 7, **caractérisé en ce que** ladite rampe (50, 60, 70, 80) définit une surface inclinée vers l'extérieur du boîtier de ventilation (1) en direction du plan d'appui (P) et parallèle à l'axe de rotation (R).

9. Dispositif selon la revendication 8, **caractérisé en ce que** chaque languette de fixation (5, 6) est constituée d'une branche sur laquelle est formée la rampe (50, 60) prolongée, en direction du plan d'appui (P), d'une surface d'appui (51a, 51b, 61a, 61b, 61c) contre laquelle vient s'appuyer le panneau (4), ladite surface d'appui définissant l'organe de blocage et étant inclinée vers l'intérieur du boîtier de ventilation (1) et parallèle à l'axe de rotation (R).

10. Dispositif selon la revendication 9, **caractérisé en ce que** la surface d'appui (51a, 51b) est plane.

11. Dispositif selon la revendication 9, **caractérisé en ce que** la surface d'appui (61a, 61b, 61c) est courbe.

12. Dispositif selon la revendication 8, **caractérisé en ce que** chaque languette de fixation (8) comporte deux branches (800, 810), une première branche (800) constituant la rampe (80), solidaire du boîtier de ventilation (1) et flexible par rapport au boîtier de ventilation (1), prolongée d'une seconde branche (810) flexible par rapport à la première branche (800) et constituant l'organe de blocage.

13. Dispositif selon la revendication 12, **caractérisé en ce que** la languette de fixation (8) comporte des moyens (82) empêchant une extraction frontale du boîtier de ventilation (1).

14. Dispositif selon la revendication 13, **caractérisé en ce que** les moyens pour empêcher l'extraction frontale sont constitués d'une entaille (82) formée sur la surface de la rampe (80) parallèlement à l'axe de rotation (R).

15. Dispositif selon la revendication 8, **caractérisé en ce que** les languettes de fixation (7) comprennent deux branches (700, 710), l'une d'elle terminée par l'extrémité libre étant repliée sur l'autre et servant de rampe (70), l'organe de blocage étant constitué de l'extrémité libre de la languette élastique (7).

16. Dispositif selon l'une des revendications 2 à 15, **caractérisé en ce que** le boîtier de ventilation (1) comporte une jupe (11) formant avec la bride (10) un épaulement perpendiculaire au plan d'appui (P) et enfoncée dans l'ouverture (2), cette jupe (11) ayant une section sensiblement rectangulaire ou carrée définissant quatre flancs (110, 111, 112, 113) portant les languettes de fixation (5, 6, 7, 8).

17. Dispositif selon la revendication 16, **caractérisé en ce que** les groupes de languettes de fixation (5, 6, 7, 8) sont identiques et répartis sur deux flancs (110, 111) opposés de la jupe (11).

18. Dispositif selon la revendication 17, **caractérisé en ce que** les languettes de centrage (9) sont formées sur les deux flancs (110, 111) opposés de la jupe (11) et **en ce que** deux groupes de languettes de fixation (5, 6, 7, 8) sont prévus sur chaque flanc (110, 111) de part et d'autre des languettes de centrage (9).

## Claims

1. Ventilation device for an electrical enclosure, housed in an opening (2) formed through a panel (4) of the electrical enclosure and comprising a ventilation casing (1) capable of accommodating a fan (V) and of being inserted into the opening (2), the said ventilation casing comprising
- a flange (10) forming a bearing plane (P) butting against a face (40) of the panel (4) so as to limit the insertion of the ventilation casing (1) into the opening (2),
- a fastening device for fastening the ventilation casing (1) in the opening, by snap-fitting onto the panel (4), when the flange (10) reaches abutment via its bearing plane (P) against the panel (4), **characterized in that**,
- the fastening device comprises several groups of several elastic fastening tabs (5, 6, 7, 8), and
- in each group, each fastening tab (5a-5b, 6a-6c, 7a-7e, 8a-8b) arranges a different space relative to the bearing plane (P) for the purpose of being able to be adapted to various thicknesses of panel (4).

2. Device according to Claim 1, **characterized in that**, in each group, the fastening tabs (5, 6, 7, 8) are juxtaposed.

3. Device according to Claim 1, **characterized in that** it comprises tabs (9) for the centring and adjustment of the ventilation casing in the opening.

4. Device according to one of Claims 1 to 3, **characterized in that** two groups of fastening tabs (5, 6, 7, 8) are placed on the ventilation casing (1) in at least two parallel rows.

5. Device according to one of Claims 1 to 4, **characterized in that** each fastening tab (5, 6, 7, 8) comprises an end secured to the ventilation casing (1) and extends in the direction of the bearing plane (P) up to a free end.

6. Device according to one of Claims 1 to 5, **characterized in that** each fastening tab (5, 6, 7, 8) can be moved by bending, when the ventilation casing (1) is snap-fitted into the opening (2), about an axis of rotation (R) parallel to the bearing plane (P).

7. Device according to one of Claims 1 to 6, **characterized in that** each fastening tab (5, 6, 7, 8) comprises:
- a ramp (50, 60, 70, 80) by which the ventilation casing (1) is engaged on the panel (4) when snap-fitted,
- an immobilization member providing retention of the ventilation casing (1) on the panel (4).

8. Device according to Claim 7, **characterized in that** the said ramp (50, 60, 70, 80) defines a surface inclined towards the outside of the ventilation casing (1) in the direction of the bearing plane (P) and parallel with the axis of rotation (R).

9. Device according to Claim 8, **characterized in that** each fastening tab (5, 6) consists of a branch on which the ramp (50, 60) is formed, extended, in the direction of the bearing plane (P), by a bearing surface (51a, 51b, 61a, 61b, 61c) against which the panel (4) presses, the said bearing surface defining the immobilization member and being inclined towards the inside of the ventilation casing (1) and being parallel to the axis of rotation (R).

10. Device according to Claim 9, **characterized in that** the bearing surface (51a, 51b) is flat.

11. Device according to Claim 9, **characterized in that** the bearing surface (61a, 61b, 61c) is curved.

12. Device according to Claim 8, **characterized in that** each fastening tab (8) comprises two branches (800, 810), a first branch (800) forming the ramp (80), secured to the ventilation casing (1) and able to flex relative to the ventilation casing (1), extended by a second branch (810) that can flex relative to the first branch (800) and forming the immobilization member.

13. Device according to Claim 12, **characterized in that** the fastening tab (8) comprises means (82) preventing a frontal extraction of the ventilation casing (1).

14. Device according to Claim 13, **characterized in that** the means for preventing the frontal extraction consists of a notch (82) formed on the surface of the ramp (80) parallel to the axis of rotation (R).

15. Device according to Claim 8, **characterized in that** the fastening tabs (7) comprise two branches (700, 710), one of them terminated by the free end being folded over the other and serving as a ramp (70), the immobilization member consisting of the free end of the elastic tab (7).

16. Device according to one of Claims 2 to 15, **characterized in that** the ventilation casing (1) comprises a skirt (11) forming, with the flange (10), a shoulder perpendicular to the bearing plane (P) and sunk into the opening (2), this skirt (11) having a substantially rectangular or square section defining four sides (110, 111, 112, 113) supporting the fastening tabs (5, 6, 7, 8).

17. Device according to Claim 16, **characterized in that** the groups of fastening tabs (5, 6, 7, 8) are identical and distributed over two opposite sides (110, 111) of the skirt (11).

18. Device according to Claim 17, **characterized in that** the centring tabs (9) are formed on the two opposite sides (110, 111) of the skirt (11) and **in that** two groups of fastening tabs (5, 6, 7, 8) are provided on each side (110, 111) on either side of the centring tabs (9).

## Patentansprüche

1. Lüftervorrichtung eines Schaltschranks, die sich in einer Öffnung (2) befindet, die durch eine Platte (4) des Elektroschranks hindurch ausgebildet ist, und ein Lüftergehäuse (1) enthält, das einen Lüfter (V) aufnehmen kann und in die Öffnung (2) eingesetzt ist, wobei das Lüftergehäuse enthält:
- einen Flansch (10), der eine Abstützebene (P) bildet, die an einer Fläche (40) der Platte (4) anliegt, derart, dass das Einsetzen des Lüftergehäuses (1) in die Öffnung (2) beschränkt ist,
- eine Befestigungsvorrichtung zum Befestigen des Lüftergehäuses (1) in der Öffnung durch Einrasten an der Platte (4), wenn der Flansch (10) mit seiner Abstützebene (P) an der Platte (4) in Anschlag gelangt,
**dadurch gekennzeichnet, dass**
- die Befestigungsvorrichtung mehrere Gruppen aus mehreren elastischen Befestigungszungen (5, 6, 7, 8) enthält und
- in jeder Gruppe jede Befestigungszunge (5a-5b, 6a-6c, 7a-7e, 8a-8b) einen unterschiedlichen Raum in Bezug auf die Abstützebene (P) freigibt, um eine Anpassung an verschiedene Dicken der Platte (4) schaffen zu können.

2. Vorrichtung nach Anspruch 1, **dadurch gekennzeichnet, dass** die Befestigungszungen (5, 6, 7, 8) in jeder Gruppe nebeneinander liegen.

3. Vorrichtung nach Anspruch 1, **dadurch gekennzeichnet, dass** sie Zungen (9) für eine Zentrierung und eine Einstellung des Lüftergehäuses in der Öffnung enthält.

4. Vorrichtung nach einem der Ansprüche 1 bis 3, **dadurch gekennzeichnet, dass** zwei Gruppen von Befestigungszungen (5, 6, 7, 8) in dem Lüftergehäuse (1) in wenigstens zwei parallelen Reihen angeordnet sind.

5. Vorrichtung nach einem der Ansprüche 1 bis 4, **dadurch gekennzeichnet, dass** jede Befestigungszunge (5, 6, 7, 8) ein mit dem Lüftergehäuse (1) fest verbundenes Ende enthält und sich in Richtung der Abstützebene (P) bis zu einem freien Ende erstreckt.

6. Vorrichtung nach einem der Ansprüche 1 bis 5, **dadurch gekennzeichnet, dass** jede Befestigungszunge (5, 6, 7, 8) beim Einrasten des Lüftergehäuses (1) in der Öffnung (2) um eine zur Abstützebene (P) parallele Drehachse (R) biegend beweglich ist.

7. Vorrichtung nach einem der Ansprüche 1 bis 6, **dadurch gekennzeichnet, dass** jede Befestigungszunge (5, 6, 7, 8) enthält:
- eine Rampe (50, 60, 70, 80), längs deren das Lüftergehäuse (1) beim Einrasten mit der Platte (4) in Eingriff gelangt,
- ein Blockierorgan, das ein Halten des Lüftergehäuses (1) an der Platte (4) verwirklicht.

8. Vorrichtung nach Anspruch 7, **dadurch gekennzeichnet, dass** die Rampe (50, 60, 70, 80) eine in die äußere Umgebung des Lüftergehäuses (1) in Richtung der Abstützebene (P) geneigte Oberfläche parallel zu der Drehachse (R) definiert.

9. Vorrichtung nach Anspruch 8, **dadurch gekennzeichnet, dass** die Befestigungszunge (5, 6) aus einem Schenkel gebildet ist, an dem die verlängerte Rampe (50, 60) in Richtung der Abstützebene (P) einer Abstützoberfläche (51a, 51b, 61a, 61b, 61c), an der sich die Platte (4) abstützt, gebildet ist, wobei die Abstützoberfläche das Blockierorgan definiert und in die innere Umgebung des Lüftergehäuses (1) geneigt ist und zu der Drehachse (R) parallel ist.

10. Vorrichtung nach Anspruch 9, **dadurch gekennzeichnet, dass** die Abstützoberfläche (51a, 51b) eben ist.

11. Vorrichtung nach Anspruch 9, **dadurch gekennzeichnet, dass** die Abstützoberfläche (61a, 61b, 61c) gekrümmt ist.

12. Vorrichtung nach Anspruch 8, **dadurch gekennzeichnet, dass** jede Befestigungszunge (8) zwei Schenkel (800, 810) enthält, wobei ein erster Schenkel (800) die mit dem Lüftergehäuse (1) fest verbundene Rampe (80) bildet, die in Bezug auf das Lüftergehäuse (1) biegsam ist und durch einen zweiten Schenkel (810) verlängert ist, der in Bezug auf den ersten Schenkel (800) biegsam ist und das Blockierorgan bildet.

13. Vorrichtung nach Anspruch 12, **dadurch gekennzeichnet, dass** die Befestigungszunge (8) Mittel (82) enthält, die ein Herausziehen des Lüftergehäuses (1) nach vorn verhindern.

14. Vorrichtung nach Anspruch 13, **dadurch gekennzeichnet, dass** die Mittel zum Verhindern des Herausziehens nach vorn durch einen Einschnitt (82) gebildet sind, der an der Oberfläche der Rampe (80) parallel zur Drehachse (R) gebildet ist.

15. Vorrichtung nach Anspruch 8, **dadurch gekennzeichnet, dass** die Befestigungszungen (7) zwei Schenkel (700, 710) enthalten, wovon einer, der durch das freie Ende abgeschlossen ist, an dem anderen umgebogen ist und als Rampe (70) dient, wobei das Blockierorgan durch das freie Ende der elastischen Zunge (7) gebildet ist.

16. Vorrichtung nach einem der Ansprüche 2 bis 15, **dadurch gekennzeichnet, dass** das Lüftergehäuse (1) eine Schürze (11) aufweist, die mit dem Flansch (10) eine zur Abstützebene (P) senkrechte Schulter bildet und in die Öffnung (2) eingesteckt ist, wobei diese Schürze (11) einen im Wesentlichen rechtwinkligen oder quadratischen Querschnitt besitzt, der vier Seitenflächen (110, 111, 112, 113) definiert, die die Befestigungszungen (5, 6, 7, 8) tragen.

17. Vorrichtung nach Anspruch 16, **dadurch gekennzeichnet, dass** die Gruppen von Befestigungszungen (5, 6, 7, 8) gleich sind und an zwei gegenüberliegenden Seitenflächen (110, 111) der Schürze (11) verteilt sind.

18. Vorrichtung nach Anspruch 17, **dadurch gekennzeichnet, dass** die Zentrierzungen (9) an den zwei gegenüberliegenden Seitenflächen (110, 111) der Schürze (11) ausgebildet sind und dass zwei Gruppen von Befestigungszungen (5, 6, 7, 8) an jeder Seitenfläche (110, 111) beiderseits der Zentrierungszungen (9) vorgesehen sind.
